(19) Europäisches Patentamt / European Patent Office / Office européen des brevets

(11) **EP 3 336 568 B1**

(12) **EUROPÄISCHE PATENTSCHRIFT**

(45) Veröffentlichungstag und Bekanntmachung des Hinweises auf die Patenterteilung:
**23.06.2021  Patentblatt 2021/25**

(51) Int Cl.:
*G01R 33/3875* (2006.01)     *G01R 33/3815* (2006.01)
*H01F 6/06* (2006.01)

(21) Anmeldenummer: **17206954.4**

(22) Anmeldetag: **13.12.2017**

(54) **MAGNETANORDNUNG MIT SUPRALEITEND GESCHLOSSENEN HTS-SHIMS**

MAGNET ASSEMBLY WITH SUPERCONDUCTING CLOSED HTS SHIMS

AGENCEMENT MAGNÉTIQUE À SHIM HTS SUPRACONDUCTEUR FERMÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.12.2016  DE 102016225017**

(43) Veröffentlichungstag der Anmeldung:
**20.06.2018  Patentblatt 2018/25**

(73) Patentinhaber: **Bruker Switzerland AG**
**8117 Fällanden (CH)**

(72) Erfinder:
• **Günter, Kenneth J.**
**8002 Zürich (CH)**
• **Schauwecker, Robert**
**8004 Zürich (CH)**

(74) Vertreter: **Kohler Schmid Möbus Patentanwälte**
**Partnerschaftsgesellschaft mbB**
**Gropiusplatz 10**
**70563 Stuttgart (DE)**

(56) Entgegenhaltungen:
**FR-A1- 2 043 465     US-A1- 2013 102 472**

**EP 3 336 568 B1**

**Beschreibung**

Die Erfindung betrifft eine Magnetanordnung für eine Magnetresonanz-Apparatur, wobei die Magnetanordnung einen Kryostaten sowie ein darin angeordnetes supraleitendes Hauptfeld-Magnetspulensystem zur Erzeugung eines Magnetfeldes in Richtung einer z-Achse in einem um den auf der z-Achse liegenden Punkt z=0 angeordneten Arbeitsvolumen enthält, wobei eine Shim-Vorrichtung zum Einstellen des räumlichen Verlaufs und/oder zur räumlichen Homogenisierung des vom Hauptfeld-Magnetspulensystem im Arbeitsvolumen erzeugten Magnetfeldes innerhalb des Kryostaten angeordnet ist, die mindestens eine supraleitend geschlossene Shim-Leiterbahn mit einer HTS(=Hochtemperatursupraleiter)-Schicht aufweist, wobei die Shim-Leiterbahn in Bezug auf die z-Achse eine Windungszahl 0 hat und die HTS-Schicht eine derart auf eine Ebene geometrisch abwickelbare Fläche bildet, dass die Geodäte in der von der HTS-Schicht gebildeten Fläche zwischen zwei beliebigen Punkten in dieser Fläche durch die geometrische Abwicklung auf eine Ebene um nicht mehr als 10% verändert wird, wobei die Shim-Leiterbahn im Betrieb ein Magnetfeld mit einer axialen Komponente $B_Z(r, z, \varphi)$ bezüglich eines Zylinderkoordinatensystems um die z-Achse erzeugt, welche dargestellt in der Basis der Kugelfunktionen um z=0 im Wesentlichen einen einzigen Feldgradienten aufweist, zuzüglich zu einem Feldgradienten 0. Grades mit Absolutbetrag >= 0, und wobei die Innen- und/oder die Außen-Kontur der geometrischen Abwicklung der durch die HTS-Schicht gebildeten Fläche eine nicht-konvexe Kurve beschreibt.

Eine Magnetspulenanordnung mit einer Shim-Vorrichtung, welche über eine supraleitende, geschlossene Shim-Leiterbahn verfügt, ist bekannt aus der US 8,965,468 B2. Darüber hinaus ist aus der Patentanmeldung FR2043465 eine Shim-Vorrichtung aus aufwickelbaren Shim-Leiterbahnen bekannt.

Hintergrund der Erfindung

Supraleiter können elektrische Ströme praktisch ohne ohmsche Verluste tragen. Sie werden insbesondere dort, wo hohe elektrische Stromstärken benötigt werden, eingesetzt, so auch in Magnetspulen.

Das Einsatzgebiet von supraleitenden Magnetsystemen umfasst verschiedene Anwendungsfelder, insbesondere Magnetresonanzverfahren. Um in solchen Verfahren eine gute Auflösung zu erreichen, muss das Magnetfeld im Probenvolumen eine hohe Homogenität aufweisen. Mit der geometrischen Anordnung der felderzeugenden Magnetspulen kann die Grundhomogenität des supraleitenden Magneten optimiert werden.

Supraleitende NMR (=Kernspinresonanz) Magnete werden üblicherweise aus NbTi oder $Nb_3Sn$ Drähten gefertigt. Aufgrund der Beschränkung, die das kritische Magnetfeld von $Nb_3Sn$ verursacht, ergibt sich derzeit eine obere Grenze von etwa 23.5 T für die maximal erreichbare Feldstärke. Dies entspricht in der NMR einer Protonenresonanzfrequenz von 1000 MHz.

Um in UHF (=Ultra-Hochfeld) Magneten höhere Feldstärken zu erreichen, muss auf alternative Leitermaterialien zurückgegriffen werden. Erforscht wird in diesem Zusammenhang derzeit hauptsächlich der Einsatz von HTS Bandleitern (z. B. ReBCO, BSCCO oder Eisen-Pniktide). Dabei wird der UHF-Magnet meist nicht komplett aus HTS Materialien gefertigt. Aus Kostengründen ist es vielmehr vorteilhaft, nur für die innersten Sektionen HTS Material zu verwenden, und den Hintergrundmagneten in konventioneller "Low-Temperature-Superconductor" (LTS) Technologie (also mit NbTi und/oder $Nb_3Sn$) zu fertigen.

HTS-Bandleiter werden auch in Magnetsystemen mit Betriebstemperaturen > 4.2 K (flüssiges Helium) eingesetzt, bei denen LTS-Spulen nicht funktionieren würden. Dies umfasst vor allem kryogen-freie Magnetsysteme, welche aktiv von einem Kryokühler auf Temperaturen von 10 - 80 K gekühlt werden.

Die z-Komponente $B_z$ des Magnetfeldes kann um das magnetische Zentrum bei z=0 auf der Achse nach Kugelfunktionen entwickelt werden (in Zylinderkoordinaten):

$$B_z(r, z, \varphi) = \sum_{n=0}^{\infty} \sum_{m=0}^{n} P_n^m \left( \frac{z}{\sqrt{r^2 + z^2}} \right) (r^2 + z^2)^{n/2} (A_{nm} \cos(m\varphi) + B_{nm} \sin(m\varphi))$$

wobei $P_n^m$ die zugeordneten Legendrepolynome sind. Die Koeffizienten $A_{nm}$ und $B_{nm}$ nennt man (Feld-)Gradienten.

n heisst der Grad, m die Ordnung des Legendrepolynoms $P_n^m$. Gradienten mit m=0 heissen on-axis, solche mit m≠0 off-axis Gradienten. Verschwinden alle Koeffizienten $A_{nm}$ und $B_{nm}$ für 0<n<=k-1, spricht man von einer Homogenität k-ten Grades. Dieser Homogenitätsgrad wird theoretisch mit einem geeigneten Design der Magnetanordnung erreicht. Da aber unvermeidliche produktionstechnische Ungenauigkeiten auftreten, wird das tatsächliche Feldprofil einer Magnetanordnung von dieser idealen Form abweichen. Um diese Abweichung zu kompensieren, sind in Magneten für Resonanzspektroskopie sogenannte Shims vorgesehen.

Die Feldstärke elektrischer Shim-Spulen kann über die Stromstärke eingestellt werden. Supraleitende Shim-Spulen werden typischerweise aus NbTi-Leiter gewickelt, weshalb sie nur bei sehr tiefen Temperaturen und in relativ tiefen Magnetfeldern eingesetzt werden können, bei welchen sie ihre supraleitende Eigenschaft nicht verlieren. Shim-Spulen, welche aus normalleitendem Material wie beispielsweise Kupfer gewickelt sind, erzeugen hingegen in der kalten Umgebung von supraleitenden Magneten wegen ihres elektrischen Widerstands unerwünschte Wärme. Shims aus magnetischen Materialien erzeugen zwar keine Wärme, da sie die Feldverteilung des supraleitenden Magneten passiv durch ihre Magnetisierung beeinflussen. Ihre Feldstärke ist jedoch nicht einstellbar, was ein großer Nachteil gegenüber elektrischen Shims darstellt.

Als einstellbare Shims in hohen Magnetfeldern oder bei höheren BetriebsTemperaturen kommen daher ausschließlich Shims aus HTS in Frage. Dies ist beispielsweise bei den oben erwähnten UHF-Magneten der Fall, bei denen die Shims vorzugsweise radial innerhalb der HTS-Spulen angeordnet werden, da die Shim-Felder sonst gegen innen stark abgeschirmt werden. Ein weiteres Anwendungsbeispiel sind kryogenfreie HTS-Magnete mit Betriebstemperaturen, bei welchen LTS nicht einsetzbar sind.

In einem orthogonalen Shimsystem erzeugt jeder Shim ein Magnetfeld, welches in der mathematischen Entwicklung nach Kugelfunktionen im Wesentlichen nur einen einzigen Gradienten aufweist. In der Praxis bedeutet dies für jeden Shim, dass die Feldvariation im Arbeitsvolumen aufgrund des jeweiligen Gradienten typischerweise mindestens fünfmal so groß ist wie die Feldvariation aufgrund desselben Gradienten jedes anderen Shims.

## Spezieller Stand der Technik

Supraleitend geschlossene HTS-Shims sind aus dem Stand der Technik bekannt und wurden vor einigen Jahren in der eingangs zitierten US 8,965,468 B2 für eine gattungsgemäße Magnetanordnung vorgeschlagen. Die supraleitend geschlossenen Strompfade eines solchen Shims verlaufen jeweils entlang dem Rand einer rechteckigen beschichteten HTS-Folie mit einer Öffnung im Zentrum und sind zylindrisch um das zu korrigierende Volumen aufgerollt.

Im Allgemeinen verlaufen die für die Feldhomogenisierung relevanten Abschnitte eines Shim-Strompfades in Bezug auf die z-Achse im Wesentlichen in azimutaler Richtung um das Arbeitsvolumen; Abschnitte des Strompfades in axialer Richtung erzeugen keine axialen Feldkomponenten und dienen bloß dazu, den Strompfad zwischen den azimutalen Abschnitten zu schließen.

Die gegenwärtig im Stand der Technik eingesetzten Lösungen weisen aufgrund des rechteckigen bzw. konvexen Verlaufs der Shim-Leiterbahnen mehrere Nachteile auf:

Eine Shim-Leiterbahn aus einer rechteckigen Folie gemäß dem genannten Stand der Technik besitzt nämlich nur je einen Abschnitt, in welchem der Strom in positiver bzw. negativer azimutaler Richtung fließt. Zur Erzeugung spezifischer Feldverteilungen, welche beispielsweise einem on-axis Feldgradienten höheren Grades oder einem off-axis Gradienten entsprechen, werden deshalb Shims mit mehreren voneinander unabhängigen supraleitend geschlossenen Leiterbahnen benötigt. Dadurch wird die Umsetzung eines Shims zur Erzeugung einer bestimmten Feldverteilung im Allgemeinen recht aufwändig. Die rechteckige Geometrie der Shim-Leiterbahnen macht eine gegenseitige induktive Entkopplung äußerst schwierig oder gar unmöglich. So kann beispielsweise eine Shim-Leiterbahn unterschiedlich stark zu den einzelnen Leiterbahnen eines anderen Shims koppeln. Infolgedessen können sich die Ströme und die Feldverteilungen eines Shims ungewollt ändern, wenn ein anderer Shim geladen wird. Außerdem benötigt jeder supraleitend geschlossene Strompfad des Shims einen separaten Schalter bzw. Heizer zum Einfahren eines elektrischen Stroms. Dies führt beim Laden des Shims zu einer erheblichen unerwünschten Wärmeerzeugung.

## Aufgabe der Erfindung

Der vorliegenden Erfindung liegt demgegenüber die Aufgabe zugrunde, eine supraleitfähige Magnetspulenanordnung der eingangs definierten Art mit möglichst einfachen, allgemein zur Verfügung stehenden technischen Mitteln so zu modifizieren, dass die oben diskutierten Einschränkungen von derartigen supraleitfähigen Magnetspulenanordnungen deutlich abgemildert oder möglichst gänzlich vermieden werden, und dass eine Verbesserung bzw. Anpassung der Feldhomogenität von supraleitenden Magneten mittels elektrischer Shims (z.B. bei Hochfeldmagneten mit HTS-Einsatzspulen oder HTS-Magneten bei Temperaturen von 10 - 80 K) ermöglicht wird.

## Kurze Beschreibung der Erfindung

Diese Aufgabe wird auf ebenso überraschend einfache wie wirkungsvolle Weise sowie mit ohne Weiteres zur Verfügung stehenden technischen Mitteln durch eine supraleitfähige Magnetspulenanordnung der eingangs definierten Art gelöst, welche sich dadurch auszeichnet, dass die Innen- und/oder die Außen-Kontur der geometrischen Abwicklung der durch die HTS-Schicht gebildeten Fläche eine nicht-konvexe Kurve beschreibt.

Wirkungsweise der Erfindung und weitere Vorteile gegenüber dem Stand der Technik

Durch den nicht-konvexen Verlauf kann eine Shim-Leiterbahn der erfindungsgemäßen Anordnung so ausgelegt werden, dass sie mehrere Abschnitte in positiver und/oder negativer azimutaler Richtung aufweist. Somit sind mit einer einzelnen supraleitend geschlossenen Shim-Leiterbahn deutlich komplexere Feldverteilungen erzeugbar als mit einer Leiterbahn aus dem Stand der Technik. Insbesondere können verschiedene Shim-Leiterbahnen derart ausgelegt werden, dass sie untereinander weitgehend induktiv entkoppelt sind. Dies hat den Vorteil, dass sie unabhängig voneinander geladen werden können, ohne dass sich dabei der Strom in anderen Shim-Leiterbahnen ändert.

Ein weiterer Vorteil der erfindungsgemäßen Anordnung liegt in der deutlich geringeren Anzahl supraleitend geschlossener Leiterbahnen, welche für die Erzeugung einer gegebenen Feldverteilung benötigt werden. Dadurch werden nämlich auch weniger supraleitende Schalter benötigt, um den elektrischen Strom in den Shim zu laden, wodurch die Wärmeerzeugung im Kryostaten reduziert ist.

Bevorzugte Ausführungsformen und Weiterbildungen der Erfindung

Die erfindungsgemäße Magnetspulenanordnung zeichnet sich dadurch aus, dass eine Shim-Leiterbahn im Betrieb ein Magnetfeld mit einer axialen Komponente $B_z(r, z, \varphi)$ bezüglich eines Zylinderkoordinatensystems um die z-Achse erzeugt, welche dargestellt in der Basis der Kugelfunktionen um den Punkt z=0 auf der z-Achse im Wesentlichen einen einzigen Feldgradienten, insbesondere zu einer der Kugelfunktionen $z^2-r^2/2$, $z^3-3/2 \cdot zr^2$, $r \cdot \cos(\varphi)$, $r \cdot \sin(\varphi)$, $3rz \cdot \cos(\varphi)$, $3rz \cdot \sin(\varphi)$, $3r^2 \cdot \cos(2\varphi)$ oder $3r^2 \cdot \sin(2\varphi)$, aufweisen, zuzüglich zu einem Feldgradienten 0. Grades mit Absolutbetrag $\geq 0$.

Mit einer orthogonalen Shim-Vorrichtung mit Shim-Leiterbahnen gemäß der vorliegenden Erfindung kann jeder Feldgradient des Hauptfeld-Magnetspulensystems durch Einstellen des elektrischen Stroms im entsprechenden Shim allein kompensiert werden, ohne dass andere Feldgradienten merklich verändert werden. Shims, welche Feldgradienten zu den genannten Kugelfunktionen erzeugen, erlauben es normalerweise, die eingangs inhomogene Feldverteilung eines Magneten hinreichend zu homogenisieren.

Eine erste Klasse von Ausführungsformen der erfindungsgemäßen Magnetspulenanordnung zeichnet sich dadurch aus, dass eine Shim-Leiterbahn durch zwei Raumteile führt, welche durch eine Ebene senkrecht zur z-Achse voneinander getrennt sind, wobei die Magnetfelder, welche im Betrieb von den Leiterabschnitten, welche in den beiden Raumteilen verlaufen, erzeugt werden, am Ort z=0 auf der z-Achse je eine z-Komponente mit gleichem Vorzeichen aufweisen. Auf solche Weise im Raum verlaufende Shim-Leiterbahnen erlauben beispielsweise die Erzeugung eines Feldgradienten zur Kugelfunktion $z^2-r^2/2$.

Eine zweite Klasse von Ausführungsformen der erfindungsgemäßen Magnetspulenanordnung zeichnet sich dadurch aus, dass eine Shim-Leiterbahn durch 2n Raumteile führt, wobei n=1, 2, 3, ..., welche durch 2n-1 Ebenen senkrecht zur z-Achse voneinander getrennt sind, wobei die Magnetfelder, welche im Betrieb von den Leiterabschnitten, welche in jeweils zwei aneinandergrenzenden Raumteilen verlaufen, erzeugt werden, am Ort z=0 auf der z-Achse je eine z-Komponente mit entgegengesetztem Vorzeichen aufweisen. Auf solche Weise im Raum verlaufende Shim-Leiterbahnen erlauben die Erzeugung von on-axis Feldgradienten zu einer Kugelfunktion ungeraden Grades, insbesondere zu den Funktionen z, $z^3-3/2 \cdot zr^2$ oder $z^5-5r^2 z^3+15/8 \cdot r^4z$. Ausserdem können solche Shim-Leiterbahnen so ausgelegt werden, dass sie voneinander weitgehend induktiv entkoppelt sind.

Eine dritte Klasse von Ausführungsformen der erfindungsgemäßen Magnetspulenanordnung zeichnet sich dadurch aus, dass eine Shim-Leiterbahn durch vier Raumteile führt, welche durch eine erste Ebene senkrecht zur z-Achse und eine zweite Ebene, welche die z-Achse beinhaltet, voneinander getrennt sind, wobei die Magnetfelder, welche im Betrieb von den Leiterabschnitten, welche in jeweils zwei an der ersten Ebene aneinandergrenzenden Raumteilen verlaufen, erzeugt werden, am Ort z=0 auf der z-Achse je eine z-Komponente mit gleichem Vorzeichen aufweisen, und wobei die Magnetfelder, welche im Betrieb von den Leiterabschnitten, welche in jeweils zwei an der zweiten Ebene aneinandergrenzenden Raumteilen verlaufen, erzeugt werden, am Ort z=0 auf der z-Achse je eine z-Komponente mit entgegengesetztem Vorzeichen aufweisen. Auf solche Weise im Raum verlaufende Shim-Leiterbahnen erlauben die Erzeugung eines off-axis Feldgradienten zur Kugelfunktion $r \cdot \cos(\varphi)$ oder $r \cdot \sin(\varphi)$.

Eine vierte Klasse von Ausführungsformen der erfindungsgemäßen Magnetspulenanordnung zeichnet sich dadurch aus, dass eine Shim-Leiterbahn durch vier Raumteile führt, welche durch eine erste Ebene senkrecht zur z-Achse und eine zweite Ebene, welche die z-Achse beinhaltet, voneinander getrennt sind, wobei die Magnetfelder, welche im Betrieb von den Leiterabschnitten, welche in jeweils zwei aneinandergrenzenden Raumteilen verlaufen, erzeugt werden, am Ort z=0 auf der z-Achse je eine z-Komponente mit entgegengesetztem Vorzeichen aufweisen. Auf solche Weise im Raum verlaufende Shim-Leiterbahnen erlauben die Erzeugung eines off-axis Feldgradienten zur Kugelfunktion $3rz \cdot \cos(\varphi)$ oder $3rz \cdot \sin(\varphi)$.

Eine fünfte Klasse von Ausführungsformen der erfindungsgemäßen Magnetspulenanordnung zeichnet sich dadurch aus, dass eine Shim-Leiterbahn durch acht Raumteile führt, welche durch eine erste Ebene senkrecht zur z-Achse und eine zweite und eine dritte Ebene, welche die z-Achse beinhalten und zueinander senkrecht sind, voneinander getrennt sind, wobei die Magnetfelder, welche im Betrieb von den Leiterabschnitten, welche in jeweils zwei an der ersten Ebene aneinandergrenzenden Raumteilen verlaufen, erzeugt werden, am Ort z=0 auf der z-Achse je eine z-Komponente mit gleichem Vorzeichen aufweisen, und wobei die Magnetfelder, welche im Betrieb von den Leiterabschnitten, welche in jeweils zwei an der zweiten oder dritten Ebene aneinandergrenzenden Raumteilen verlaufen, erzeugt werden, am Ort z=0 auf der z-Achse je eine z-Komponente mit entgegengesetztem Vorzeichen aufweisen. Auf solche Weise im Raum verlaufende Shim-Leiterbahnenerlauben die Erzeugung eines off-axis Feldgradienten zur Kugelfunktion $3r^2 \cdot \cos(2\varphi)$ oder $3r^2 \cdot \sin(2\varphi)$.

Die einzelnen Ausführungsformen gemäß den oben beschriebenen fünf Klassen können alternativ, teilweise aber auch ergänzend oder gemischt verwirklicht sein.

Ganz besonders bevorzugt ist auch eine weitere Klasse von Ausführungsformen der erfindungsgemäßen Magnetspulenanordnung, bei denen eine Shim-Leiterbahn in der Projektion auf einen Zylinder um die z-Achse mehr als zwei in azimutaler Richtung verlaufende Leiterabschnitte umfasst, welche durch in andere Richtungen verlaufende Verbindungsabschnitte elektrisch miteinander verbunden sind. Shim-Leiterbahnen mit dieser Geometrie sind in zylindersymmetrischen Hauptfeld-Magnetspulensystemen, wie beispielsweise in Solenoidmagneten, aus Symmetrie- und Platzgründen besonders geeignet. Leiterabschnitte in azimutaler Richtung sind für die Homogenisierung des Hauptfeld-Magnetspulensystem relevant, da sie Feldkomponenten in Richtung der z-Achse erzeugen.

Weitere vorteilhafte Ausführungsformen der erfindungsgemäßen Magnetspulenanordnung zeichnen sich dadurch aus, dass eine Shim-Leiterbahn aus einem HTS-Bandleiter oder aus einer HTS-beschichteten Folie gefertigt ist, wobei das HTS-Material aus ReBCO (Metall der Seltenen Erden (Re) kombiniert mit Barium-Kupferoxid (BCO)), insbesondere YBCO oder GdBCO, oder BSCCO besteht. Supraleitend geschlossene, HTS-beschichtete Shim-Leiterbahnen können besonders einfach aus Bandleitern oder Folien ausgeschnitten, gestanzt, lasergeschnitten, geätzt oder ähnlich gefertigt werden. Die genannten HTS-Materialien eignen sich besonders gut als Leiter für die erfindungsgemäßen Magnetanordnungen und sind in entsprechender Form herstellbar.

Besonders bevorzugt sind auch Ausführungsformen der Erfindung, bei denen die Shim-Vorrichtung mindestens zwei supraleitend geschlossene Shim-Leiterbahnen aufweist, welche voneinander weitgehend induktiv entkoppelt sind, insbesondere derart, dass $|L_{12}|/\sqrt{L_1 L_2} \leq 0.2$, wobei $L_1$ und $L_2$ die Eigeninduktivitäten der beiden Shim-Leiterbahnen und $L_{12}$ deren Gegeninduktivität sind. Induktiv entkoppelte Shim-Leiterbahnen können unabhängig voneinander geladen werden, ohne dass sich der Strom in den anderen Shim-Leiterbahnen passiv ändert.

Weitere bevorzugte Ausführungsform der Erfindung zeichnen sich dadurch aus, dass eine Shim-Leiterbahn in der Projektion auf einen Zylinder um die z-Achse sich selber überlappt oder kreuzt, insbesondere dass sie in mehr als einer Lage zylinderförmig um das Arbeitsvolumen aufgerollt ist und/oder dass die abwickelbare HTS-Schicht mindestens eine Änderung der Umlaufrichtung um die z-Achse aufweist. Mehrlagige Shim-Leiterbahnen bieten mehr Freiheitsgrade beim Design und erlauben die Erzeugung komplexerer Feldverteilungen. Außerdem können mehrere Lagen dazu verwendet werden, die Effizienz der Leiterbahn (Feldstärke pro Stromstärke) zu erhöhen. Eine Änderung der Umlaufsrichtung der HTS-Schicht um die z-Achse kann in gewissen Fällen die induktive Entkopplung einer Shim-Leiterbahn von anderen Shim-Leiterbahnen erleichtern oder gar erst ermöglichen.

Bei weiteren vorteilhaften Ausführungsformen der erfindungsgemäßen Magnetanordnung umfasst die Shim-Vorrichtung mehrere bezüglich der z-Achse radial übereinander angeordnete und axial und azimutal gleich verlaufende supraleitend geschlossene Shim-Leiterbahnen. Eine Einheit derart angeordneter Shim-Leiterbahnen ist effizienter als eine einzelne Shim-Leiterbahn, d.h. sie erzeugt eine größere Feldstärke pro Stromstärke.

In der Praxis bewähren sich auch Ausführungsformen der erfindungsgemäßen Spulenanordnung, bei welchen eine Shim-Leiterbahn einen supraleitenden Schalter aufweist. Bei geöffnetem supraleitendem Schalter kann ein elektrischer Strom in die Shim-Leiterbahn eingefahren werden, welcher nach dem Schließen des Schalters persistent in der supraleitend geschlossenen Shim-Leiterbahn fließt.

Von großem praktischem Vorteil sind auch Ausführungsformen, die sich dadurch auszeichnen, dass das supraleitende Hauptfeld-Magnetspulensystem Spulen aus HTS-Leiter umfasst und dass das Hauptfeld-Magnetspulensystem und die Shim-Vorrichtung durch einem Kryokühler auf eine Temperatur zwischen 10 K und 80 K gekühlt werden. Höhere als die für den Einsatz von LTS-Material erforderlichen Betriebstemperaturen um 4 K reduzieren die notwendige Kühlleistung. Betriebstemperaturen zwischen 10 K und 80 K können durch effiziente Kryokühler erreicht werden. In diesem Temperaturbereich ist der Einsatz von HTS für supraleitende Shims unumgänglich.

Bei weiteren bevorzugten Ausführungsformen der erfindungsgemäßen Magnetanordnung verläuft eine Shim-Leiterbahn bezüglich der z-Achse mindestens teilweise radial innerhalb des supraleitenden Hauptfeld-Magnetspulensystems. Supraleitende HTS-Shims radial innerhalb des Hauptfeld-Magnetspulensystems sind effizienter und werden deutlich weniger vom Hauptfeld-Magnetspulensystem abgeschirmt. Bei sehr starken Magnetfeldern in diesem Bereich sind aktive supraleitende Shims nur aus HTS möglich, da die Stromtragfähigkeit von LTS unzureichend wäre. Dies ist beispielsweise bei UHF-Magnetsystemen mit HTS-Einsatzspulen der Fall. Schließlich fällt in den Rahmen der vorliegenden Erfindung auch ein Magnetresonanz-Spektrometer mit einer Magnetspulenanordnung der oben beschriebenen erfindungsgemäßen Art.

Detaillierte Beschreibung der Erfindung und Zeichnung

Die Erfindung ist in der Zeichnung dargestellt und wird anhand von Ausführungsbeispielen näher erläutert. Es zeigen:

Fig. 1      eine schematische Darstellung einer erfindungsgemäßen Magnetanordnung in einer Magnetresonanz-Apparatur;

Fig. 2a     eine schematische Darstellung einer Shim-Leiterbahn zur Erzeugung eines on-axis Feldgradienten zur Kugelfunktion $z^2-r^2/2$;

Fig. 2b     eine schematische Darstellung einer Shim-Leiterbahn zur Erzeugung eines on-axis Feldgradienten zur Kugelfunktion $z^2-r^2/2$;

Fig. 3      eine schematische Darstellung einer Shim-Leiterbahn zur Erzeugung eines on-axis Feldgradienten zur Kugelfunktion $z^3-3/2\cdot zr^2$;

Fig. 4a     eine schematische Darstellung einer Shim-Leiterbahn zur Erzeugung eines off-axis Feldgradienten zur Kugelfunktion $r\cdot\sin(\varphi)$;

Fig. 4b     die Anordnung nach Fig. 4a in räumlicher Ansicht;

Fig. 5a     eine schematische Darstellung einer Shim-Leiterbahn zur Erzeugung eines off-axis Feldgradienten zur Kugelfunktion $3r\cdot z\cdot\sin(\varphi)$;

Fig. 5b     die Anordnung nach Fig. 5a in räumlicher Ansicht;

Fig. 6      eine schematische Darstellung einer Shim-Leiterbahn zur Erzeugung eines off-axis Feldgradienten zur Kugelfunktion $3r^2\cdot\cos(2\varphi)$;

Fig. 7a     eine schematische Darstellung einer Shim-Leiterbahn zur Erzeugung eines on-axis Feldgradienten zur Kugelfunktion $z^2-r^2/2$;

Fig. 7b     die Anordnung nach Fig. 7b nach einer Faltung in der Mitte; und

Fig. 8      eine schematische Darstellung einer Shim-Leiterbahn mit einem supraleitenden Schalter und Stromzuleitungen.

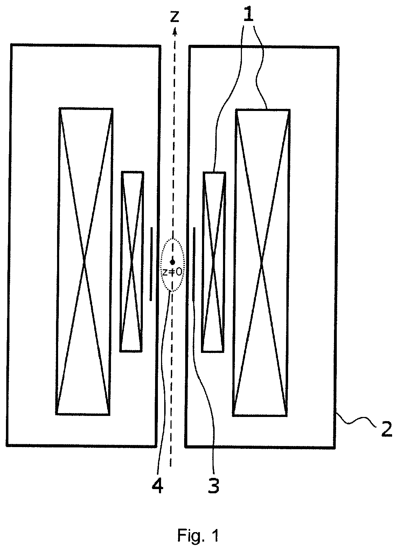

In Fig. 1 ist eine Ausführung der erfindungsgemäßen Magnetanordnung in einer Magnetresonanz-Apparatur schematisch dargestellt. Ein Hauptfeld-Magnetspulensystem 1 ist in einem Kryostaten 2 angeordnet und erzeugt ein Magnetfeld in Richtung einer z-Achse in einem um den auf der z-Achse liegendem Punkt z=0 angeordneten Arbeitsvolumen 4. Radial innerhalb des Hauptfeld-Magnetspulensystems 1 ist eine Shim-Vorrichtung 3 zum Einstellen des räumlichen Verlaufs und/oder zur räumlichen Homogenisierung des vom Hauptfeld-Magnetspulensystem 1 im Arbeitsvolumen 4 erzeugten Magnetfeldes angeordnet. Die Shim-Vorrichtung 3 weist mindestens eine supraleitend geschlossene Shim-Leiterbahn auf, welche in Bezug auf die z-Achse eine Windungszahl 0 hat. Die HTS-Schicht der Shim-Leiterbahn bildet eine geometrisch abwickelbare Fläche, deren Innen- und/oder Außen-Kontur eine nicht-konvexe Kurve beschreibt.

Zur Herstellung einer supraleitend geschlossenen Shim-Leiterbahn in der erfindungsgemäßen Magnetanordnung kann beispielsweise ein geschlossener Strompfad aus einer HTS-beschichteten Folie ausgeschnitten werden.

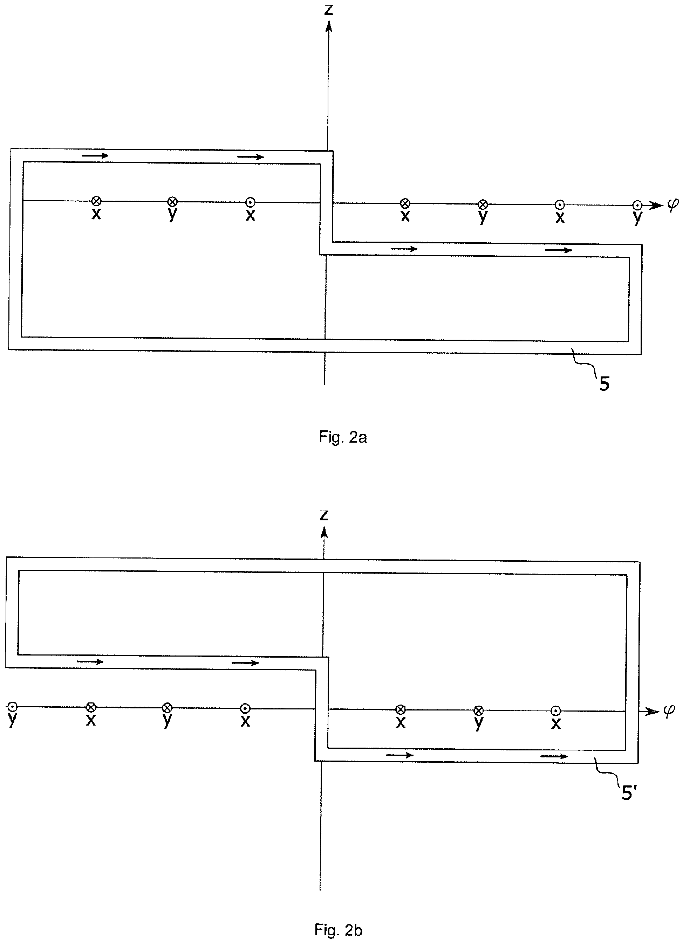

Zur Erzeugung gewisser Feldgradienten kann eine Shim-Leiterbahn der erfindungsgemäßen Anordnung auch in mehreren Lagen um das Arbeitsvolumen 4 gewickelt sein. Die Figuren 2a und 2b zeigen schematisch Beispiele von Shim-Leiterbahnen 5; 5', welche einen Feldgradienten zur Kugelfunktion $z^2-r^2/2$ erzeugen, wenn sie in zwei Lagen zylindrisch um das Arbeitsvolumen 4 aufgerollt sind und einen elektrischen Strom tragen.

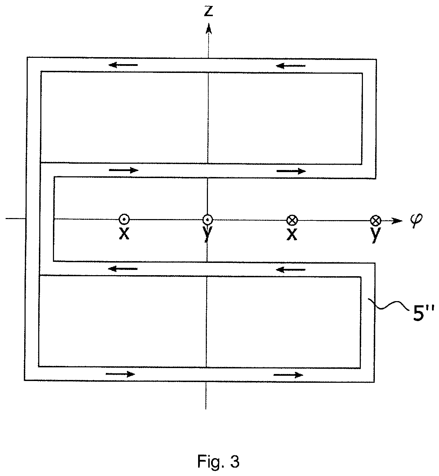

Fig. 3 zeigt als Beispiel einen Shim bestehend aus einer Leiterbahn 5" mit vier azimutal verlaufenden Abschnitten, welcher in einem Arbeitsvolumen 4 im Wesentlichen ein Magnetfeld mit einem on-axis Feldgradienten zur Kugel-

funktion $z^3-3/2 \cdot zr^2$ erzeugt, wenn er zylindrisch um das Arbeitsvolumen 4 aufgerollt ist und einen elektrischen Strom trägt. Während man hier mit einem einzigen supraleitend geschlossenen Strompfad beispielsweise mit einer HTS-Folie auskommt, werden für den analogen Shim gemäß dem Stand der Technik mindestens zwei rechteckige supraleitend geschlossene Leiterbahnen benötigt, um eine ähnliche Feldverteilung zu generieren.

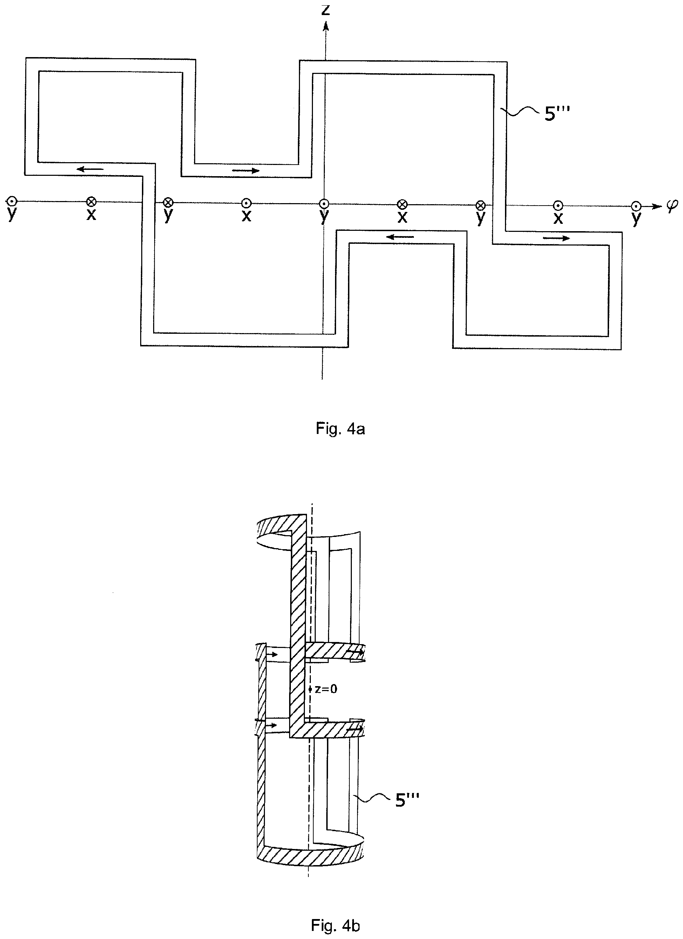

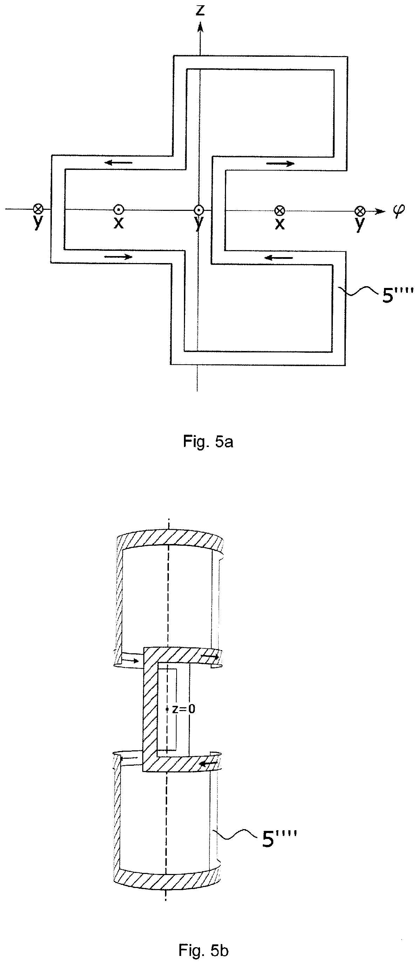

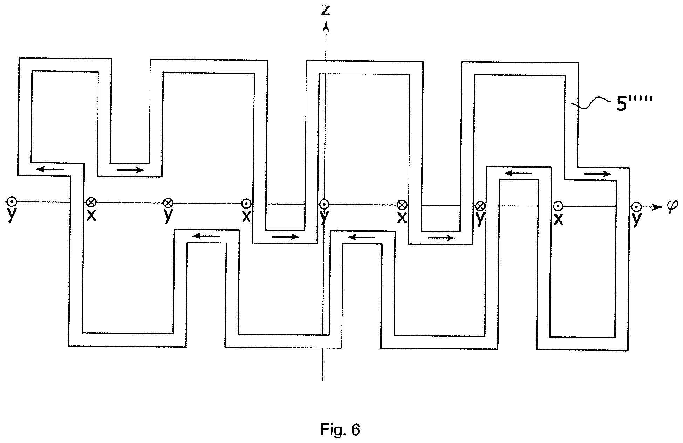

Die erfindungsgemäße Anordnung umfasst auch HTS-Shims zur Erzeugung von off-axis Gradienten, wie beispielsweise dargestellt in den Figuren 4a - 6. Die Realisierung solcher Shims mit jeweils einer einzigen supraleitend geschlossenen Leiterbahn 5''', 5'''' bzw. 5''''' ist nur dank dem nicht-konvexen Verlauf der geometrischen Abwicklung der HTS-Schicht (Figuren 4a, 5a und 6) möglich. In den Figuren 4a und 4b ist eine Leiterbahn 5''' zur Erzeugung eines Feldgradienten zur Kugelfunktion $r \cdot \sin(\varphi)$ zu sehen, wenn sie in zwei Lagen zylindrisch um das Arbeitsvolumen 4 aufgerollt ist und einen elektrischen Strom trägt. Die Figuren 5a und 5b stellen eine Leiterbahn 5'''' zur Erzeugung eines Feldgradienten zur Kugelfunktion $3r \cdot z \cdot \sin(\varphi)$ dar, wenn sie zylindrisch um das Arbeitsvolumen 4 aufgerollt ist und einen elektrischen Strom trägt. Die Figuren 4b und 5b zeigen eine räumliche Darstellung der Shim-Leiterbahnen der entsprechenden Figuren 4a und 5a. Die Shim-Leiterbahn 5''''' in Fig. 6 wird in zwei Lagen zylindrisch um die z-Achse angeordnet und erzeugt einen Feldgradienten zur Kugelfunktion $3r^2 \cdot \cos(2\varphi)$, wenn sie einen elektrischen Strom trägt.

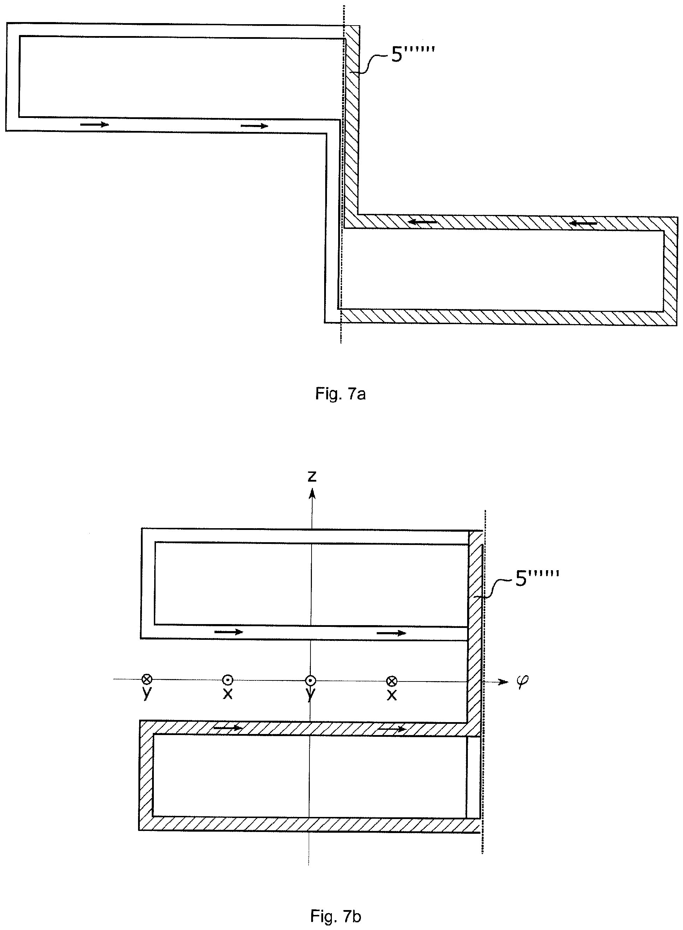

Die Figuren 7a und 7b zeigen eine Shim-Leiterbahn 5'''''' einer erfindungsgemäßen Anordnung, welche sich in der Projektion auf einen Zylinder um die z-Achse selber überlappt. In Fig. 7a ist die komplette geometrische Abwicklung der Leiterbahn 5'''''' auf eine Ebene dargestellt, und Fig. 7b zeigt die in der Mitte in azimutaler Richtung zurückgefaltete oder - gebogene Leiterbahn 5'''''' so, wie sie auf einen Zylinder um die z-Achse aufgewickelt wird. Auf diese Weise wird in diesem Beispiel mit einer einzigen symmetrischen Leiterbahn ein Shim mit einem Feldgradienten zur Kugelfunktion $z^2-r^2/2$ realisiert.

Die beiden in den Figuren 2a und 2b dargestellten supraleitend geschlossenen Leiterbahnen 5 und 5' können beispielsweise auch gemeinsam als Shim zur Erzeugung eines Feldgradienten zur Kugelfunktion $z^2-r^2/2$ verwendet werden. Ein solcher Shim erzeugt aus Symmetriegründen keine Fremdgradienten zu Kugelfunktionen ungeraden Grades, und jede der beiden Leiterbahnen 5; 5' ist einzeln durch ihre Form weitgehend von Shims zur Erzeugung von on-axis Feldgradienten zu Kugelfunktionen ungeraden Grades induktiv entkoppelt.

Als Ausführungsbeispiel kann folgende Geometrie für die Shim-Leiterbahn 5 auf einem konstanten Radius von 35 mm um das Arbeitsvolumen 3 betrachtet werden: Die beiden kurzen azimutal verlaufenden Leiterabschnitte der Leiterbahn 5 haben eine z-Koordinate von jeweils $\pm 10$ mm, und der lange azimutal verlaufende Leiterabschnitt, welcher sich zweimal um das Arbeitsvolumen windet, habe eine z-Koordinate von -36 mm. Außerdem sei die Breite der Leiterbahn 5 4 mm. Die on-axis Feldgradienten bis zum 8. Grad am Ort z=0 auf der z-Achse bei einem Strom von 100 A berechnen sich zu:

| Gradient $A_{n0}$ | Stärke ($G/cm^n$) |
|---|---|
| $A_{00}$ | 19.7 |
| $A_{10}$ | 5.21 |
| $A_{20}$ | -3.38 |
| $A_{30}$ | 0.101 |
| $A_{40}$ | 0.0483 |
| $A_{50}$ | -0.0123 |
| $A_{60}$ | 0.0171 |
| $A_{70}$ | -0.000262 |
| $A_{80}$ | -0.00227 |

Abgesehen vom homogenen Feldbeitrag $A_{00}$ erzeugt der Shim hauptsächlich einen Gradienten $A_{10}$ zur Kugelfunktion z und einen Gradienten $A_{20}$ zur Kugelfunktion $z^2-r^2/2$. Off-axis Gradienten entstehen aufgrund der Zylindersymmetrie des Shims nicht.

Ein solcher Shim kann aus einer 50 mm breiten HTS-beschichteten Folie hergestellt werden. Stehen noch breitere HTS-beschichtete Folien zur Verfügung, so kann der lange azimutal verlaufende Leiterabschnitt noch weiter weg von z=0 gewählt werden, um die Gradienten ungeraden Grades zu verringern. Außerdem kann auf diese Weise auch die induktive Kopplung zu anderen Shims verkleinert werden. Befindet sich der lange Leiterabschnitt beispielsweise bei z=-42 mm anstatt bei z=-36 mm, so reduziert sich der Kopplungskoeffizient $|L_{12}|/\sqrt{L_1 L_2}$ zu einem z-Shim von 0.30 auf 0.18. Als z-Shim wurde hier eine einlagige Leiterbahn mit rechteckiger Abwicklung angenommen, deren azimutale Leiterabschnitte auf dem Radius 35 mm bei z=±30 mm verlaufen.

Als nächstes wird ein Shim bestehend aus zwei Leiterbahnen 5; 5' betrachtet, welcher aus Symmetriegründen keine Gradienten ungeraden Grades erzeugt. Die Geometrie sei folgende: Die beiden kurzen azimutal verlaufenden Leiterabschnitte der Leiterbahnen 5; 5' haben eine z-Koordinate von jeweils ±10 mm, und die langen azimutal verlaufenden Leiterabschnitte eine z-Koordinate von -36 mm bzw. +36 mm. Die Breite der Leiterbahnen 5; 5' betrage wiederum 4 mm. Bei 100 A Strom erzeugt der Shim folgende Feldgradienten bis zum 8. Grad:

| Gradient $A_{n0}$ | Stärke (G/cm$^n$) |
| --- | --- |
| $A_{00}$ | 39.4 |
| $A_{20}$ | -6.76 |
| $A_{40}$ | 0.0968 |
| $A_{60}$ | 0.0342 |
| $A_{80}$ | -0.00453 |

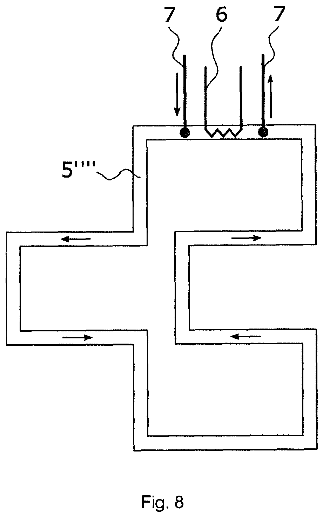

Fig. 8 zeigt als Beispiel schematisch eine Shim-Leiterbahn 5'''' einer erfindungsgemäßen Anordnung mit einem supraleitenden Schalter 6. Um die Shim-Leiterbahn 5'''' mit einem elektrischen Strom zu laden, kann der supraleitende Schalter 6 geöffnet werden, indem er beispielsweise durch Heizen normalleitend gemacht wird. Der Strom kann dann über die Zuleitungen 7 in die Leiterbahn 5'''' eingefahren werden. Nach Schließen des supraleitenden Schalters (6) fließt der Strom persistent in der supraleitend geschlossenen Shim-Leiterbahn 5'''', und die Stromzufuhr über die Zuleitungen 7 kann ausgeschaltet werden.

**Bezugszeichenliste:**

| | |
| --- | --- |
| 1 | Hauptfeld-Magnetspulensystem |
| 2 | Kryostat |
| 3 | Shim-Vorrichtung |
| 4 | Arbeitsvolumen |
| 5, 5', 5", 5''', 5'''', 5''''', 5'''''' | Shim-Leiterbahn mit HTS-Schicht |
| 6 | supraleitender Schalter |
| 7 | Stromzuleitungen |

**Patentansprüche**

1. Magnetanordnung für eine Magnetresonanz-Apparatur, wobei die Magnetanordnung einen Kryostaten (2) sowie ein darin angeordnetes supraleitendes Hauptfeld-Magnetspulensystem (1) zur Erzeugung eines Magnetfeldes in Richtung einer z-Achse in einem um den auf der z-Achse liegenden Punkt z=0 angeordneten Arbeitsvolumen (4) enthält, wobei eine Shim-Vorrichtung (3) zum Einstellen des räumlichen Verlaufs und/oder zur räumlichen Homogenisierung des vom Hauptfeld-Magnetspulensystem (1) im Arbeitsvolumen (4) erzeugten Magnetfeldes innerhalb des Kryostaten (2) angeordnet ist, die mindestens eine supraleitend geschlossene Shim-Leiterbahn (5, 5', 5", 5''', 5'''', 5''''', 5'''''') mit einer Hochtemperatursupraleiter-Schicht, abgekürzt HTS-Schicht, aufweist,

   **dadurch gekennzeichnet,**

   **dass** die Shim-Leiterbahn (5, 5', 5", 5''', 5'''', 5''''', 5'''''') in Bezug auf die z-Achse eine Windungszahl 0 hat und die HTS-Schicht eine derart auf eine Ebene geometrisch abwickelbare Fläche bildet, dass die Geodäte in der von der HTS-Schicht gebildeten Fläche zwischen zwei beliebigen Punkten in dieser Fläche durch die geometrische Abwicklung auf eine Ebene um nicht mehr als 10% verändert wird,

   **dass** die Shim-Leiterbahn (5, 5', 5", 5''', 5'''', 5''''', 5'''''') im Betrieb ein Magnetfeld mit einer axialen Komponente $B_z(r, z, \varphi)$ bezüglich eines Zylinderkoordinatensystems um die z-Achse erzeugt, welche dargestellt in der Basis der Kugelfunktionen um z=0 im Wesentlichen einen einzigen Feldgradienten aufweist, zuzüglich zu einem Feldgradienten 0. Grades mit Absolutbetrag ≥0, und

   **dass** die Innen- und/oder die Außen-Kontur der geometrischen Abwicklung der durch die HTS-Schicht gebildeten Fläche eine nicht-konvexe Kurve beschreibt.

**2.** Magnetanordnung nach Anspruch 1, **dadurch gekennzeichnet, dass** eine Shim-Leiterbahn (5, 5', 5", 5''', 5'''', 5''''', 5'''''') einen einzigen Feldgradienten zu einer der Kugelfunktionen $z^2$-$r^2$/2, $z^3$-3/2·$zr^2$, r·cos($\varphi$), r·sin($\varphi$), 3rz·cos($\varphi$), 3rz·sin($\varphi$), 3$r^2$·cos(2$\varphi$) oder 3$r^2$·sin(2$\varphi$) erzeugt.

**3.** Magnetanordnung nach einem der vorhergehenden Ansprüche, **dadurch gekennzeichnet, dass** eine Shim-Leiterbahn (5, 5', 5'''''') durch zwei Raumteile führt, welche durch eine Ebene senkrecht zur z-Achse voneinander getrennt sind, wobei die Magnetfelder, welche im Betrieb von den Leiterabschnitten, welche in den beiden Raumteilen verlaufen, erzeugt werden, am Ort z=0 auf der z-Achse je eine z-Komponente mit gleichem Vorzeichen aufweisen.

**4.** Magnetanordnung nach einem der vorhergehenden Ansprüche, **dadurch gekennzeichnet, dass** eine Shim-Leiterbahn (5") durch 2n Raumteile führt, wobei n=1, 2, 3, ..., welche durch 2n-1 Ebenen senkrecht zur z-Achse voneinander getrennt sind, wobei die Magnetfelder, welche im Betrieb von den Leiterabschnitten, welche in jeweils zwei aneinandergrenzenden Raumteilen verlaufen, erzeugt werden, am Ort z=0 auf der z-Achse je eine z-Komponente mit entgegengesetztem Vorzeichen aufweisen.

**5.** Magnetanordnung nach einem der vorhergehenden Ansprüche, **dadurch gekennzeichnet, dass** eine Shim-Leiterbahn (5''') durch vier Raumteile führt, welche durch eine erste Ebene senkrecht zur z-Achse und eine zweite Ebene, welche die z-Achse beinhaltet, voneinander getrennt sind, wobei die Magnetfelder, welche im Betrieb von den Leiterabschnitten, welche in jeweils zwei an der ersten Ebene aneinandergrenzenden Raumteilen verlaufen, erzeugt werden, am Ort z=0 auf der z-Achse je eine z-Komponente mit gleichem Vorzeichen aufweisen, und wobei die Magnetfelder, welche im Betrieb von den Leiterabschnitten, welche in jeweils zwei an der zweiten Ebene aneinandergrenzenden Raumteilen verlaufen, erzeugt werden, am Ort z=0 auf der z-Achse je eine z-Komponente mit entgegengesetztem Vorzeichen aufweisen.

**6.** Magnetanordnung nach einem der vorhergehenden Ansprüche, **dadurch gekennzeichnet, dass** eine Shim-Leiterbahn (5"") durch vier Raumteile führt, welche durch eine erste Ebene senkrecht zur z-Achse und eine zweite Ebene, welche die z-Achse beinhaltet, voneinander getrennt sind, wobei die Magnetfelder, welche im Betrieb von den Leiterabschnitten, welche in jeweils zwei aneinandergrenzenden Raumteilen verlaufen, erzeugt werden, am Ort z=0 auf der z-Achse je eine z-Komponente mit entgegengesetztem Vorzeichen aufweisen.

**7.** Magnetanordnung nach einem der vorhergehenden Ansprüche, **dadurch gekennzeichnet, dass** eine Shim-Leiterbahn (5''''') durch acht Raumteile führt, welche durch eine erste Ebene senkrecht zur z-Achse und eine zweite und eine dritte Ebene, welche die z-Achse beinhalten und zueinander senkrecht sind, voneinander getrennt sind, wobei die Magnetfelder, welche im Betrieb von den Leiterabschnitten, welche in jeweils zwei an der ersten Ebene aneinandergrenzenden Raumteilen verlaufen, erzeugt werden, am Ort z=0 auf der z-Achse je eine z-Komponente mit gleichem Vorzeichen aufweisen, und wobei die Magnetfelder, welche im Betrieb von den Leiterabschnitten, welche in jeweils zwei an der zweiten oder dritten Ebene aneinandergrenzenden Raumteilen verlaufen, erzeugt werden, am Ort z=0 auf der z-Achse je eine z-Komponente mit entgegengesetztem Vorzeichen aufweisen.

**8.** Magnetanordnung nach einem der vorhergehenden Ansprüche , **dadurch gekennzeichnet, dass** eine Shim-Leiterbahn (5, 5', 5", 5''', 5'''', 5''''', 5'''''') in der Projektion auf einen Zylinder um die z-Achse mehr als zwei in azimutaler Richtung verlaufende Leiterabschnitte umfasst, welche durch in andere Richtungen verlaufende Verbindungsabschnitte elektrisch miteinander verbunden sind.

**9.** Magnetanordnung nach einem der vorhergehenden Ansprüche, **dadurch gekennzeichnet, dass** eine Shim-Leiterbahn (5, 5', 5", 5''', 5'''', 5''''', 5'''''') aus einem HTS-Bandleiter oder aus einer HTS-beschichteten Folie gefertigt ist, wobei das HTS-Material aus ReBCO, insbesondere YBCO oder GdBCO, oder BSCCO besteht.

**10.** Magnetanordnung nach einem der vorhergehenden Ansprüche, **dadurch gekennzeichnet, dass** die Shim-Vorrichtung (3) mindestens zwei supraleitend geschlossene Shim-Leiterbahnen (5, 5', 5", 5''', 5'''', 5''''', 5'''''') aufweist, welche voneinander derart induktiv entkoppelt sind, $\mathrm{dass} |L_{12}|/\sqrt{L_1 L_2} \leq 0.2$, wobei $L_1$ und $L_2$ die Eigeninduktivitäten der beiden Shim-Leiterbahnen und $L_{12}$ deren Gegeninduktivität sind.

**11.** Magnetanordnung nach einem der vorhergehenden Ansprüche, **dadurch gekennzeichnet, dass** eine Shim-Leiterbahn (5, 5', 5''', 5"", 5''''') in der Projektion auf einen Zylinder um die z-Achse sich selber überlappt oder kreuzt, insbesondere dass sie in mehr als einer Lage zylinderförmig um das Arbeitsvolumen (4) aufgerollt ist und/oder dass die abwickelbare HTS-Schicht mindestens eine Änderung der Umlaufrichtung um die z-Achse aufweist.

12. Magnetanordnung nach einem der vorhergehenden Ansprüche, **dadurch gekennzeichnet, dass** die Shim-Vorrichtung (3) mehrere bezüglich der z-Achse radial übereinander angeordnete und axial und azimutal gleich verlaufende supraleitend geschlossene Shim-Leiterbahnen (5, 5', 5", 5''', 5'''', 5''''', 5'''''') umfasst.

13. Magnetanordnung nach einem der vorhergehenden Ansprüche, **dadurch gekennzeichnet, dass** eine Shim-Leiterbahn (5, 5', 5", 5''', 5'''', 5''''', 5'''''') einen supraleitenden Schalter (6) aufweist.

14. Magnetanordnung nach einem der vorhergehenden Ansprüche, **dadurch gekennzeichnet, dass** das supraleitende Hauptfeld-Magnetspulensystem (1) Spulen aus HTS-Leiter umfasst und dass das Hauptfeld-Magnetspulensystem (1) und die Shim-Vorrichtung (3) durch einem Kryokühler auf eine Temperatur zwischen 10 K und 80 K gekühlt werden.

15. Magnetanordnung nach einem der vorhergehenden Ansprüche, **dadurch gekennzeichnet, dass** eine Shim-Leiterbahn (5, 5', 5", 5''', 5'''', 5''''', 5'''''') bezüglich der z-Achse radial mindestens teilweise innerhalb des supraleitenden Hauptfeld-Magnetspulensystems (1) verläuft.

**Claims**

1. Magnet assembly for a magnetic resonance apparatus, the magnet assembly comprising a cryostat (2) and a superconducting main field magnet coil system (1) arranged therein for generating a magnetic field in the direction of a z-axis in a working volume (4) arranged around the point z=0 on the z-axis, with a shim device (3) arranged inside the cryostat (2) for adjusting the spatial variation and/or spatial homogenization of the magnetic field generated in the working volume (4) by the main field magnet coil system (1), which shim device comprises at least one closed superconducting shim current path (5, 5', 5", 5''', 5'''', 5''''', 5'''''') having a high-temperature superconductor layer, abbreviated HTS layer,
   **characterized in that** the shim current path (5, 5', 5", 5''', 5'''', 5''''', 5'''''') has a winding number of 0 with respect to the z-axis,
   and the HTS layer forms a surface that is geometrically developable on a plane in such a way that the geometrical unwrapping on a plane changes the geodesic between any two points in the surface formed by the HTS layer by no more than 10%,
   that, during operation, the shim current path (5, 5', 5", 5''', 5'''', 5''''', 5'''''') generates a magnetic field with an axial component $B_z(r, z, \varphi)$ with respect to a cylindrical coordinate system about the z-axis which, represented in the basis of the spherical harmonics about z=0, essentially has a single field gradient in addition to a field gradient of zero order with an absolute value of $\geq 0$, and
   that the inner and/or outer contour of the geometrically developed surface formed by the HTS layer describes a non-convex curve.

2. Magnet assembly according to claim 1, **characterized in that** a shim current path (5, 5', 5", 5''', 5'''', 5''''', 5'''''') generates a single field gradient for one of the spherical harmonics $z^2-r^2/2$, $z^3-3/2\cdot zr^2$, $r\cdot\cos(\varphi)$, $r\cdot\sin(\varphi)$, $3rz\cdot\cos(\varphi)$, $3rz\cdot\sin(\varphi)$, $3r^2\cdot\cos(2\varphi)$ or $3r^2\cdot\sin(2\varphi)$.

3. Magnet assembly according to either of the preceding claims, **characterized in that** a shim current path (5, 5', 5'''''') passes through two spaces that are separated from one another by a plane perpendicular to the z-axis, the magnetic fields generated, during operation, by the conductor portions that extend in the two spaces both having a z-component of the same sign at location z=0 on the z-axis.

4. Magnet assembly according to any of the preceding claims, **characterized in that** a shim current path (5") passes through 2n spaces, n being equal to 1, 2, 3, etc., which spaces are separated from one another by 2n-1 planes perpendicular to the z-axis, the magnetic fields generated, during operation, by the conductor portions that extend in each case in two adjacent spaces each having a z-component of opposite sign at location z=0 on the z-axis.

5. Magnet assembly according to any of the preceding claims, **characterized in that** a shim current path (5''') passes through four spaces that are separated from one another by a first plane that is perpendicular to the z-axis, and by a second plane that contains the z-axis, the magnetic fields generated during operation of the conductor portions that extend in each case in two spaces adjacent to one another on the first plane each having a z-component of the same sign at location z=0 on the z-axis, and the magnetic fields generated, during operation, by the conductor portions that extend in each case in two spaces adjacent to one another on the second plane each having a z-component of opposite sign at location z=0 on the z-axis.

6. Magnet assembly according to any of the preceding claims, **characterized in that** a shim current path (5"") passes through four spaces that are separated from one another by a first plane that is perpendicular to the z-axis, and by a second plane that contains the z-axis, the magnetic fields generated, during operation, by the conductor portions that extend in each case in two adjacent spaces each having a z-component of opposite sign at location z=0 on the z-axis.

7. Magnet assembly according to any of the preceding claims, **characterized in that** a shim current path (5""") passes through eight spaces that are separated from one another by a first plane that is perpendicular to the z-axis, and by a second and a third plane that contain the z-axis and are perpendicular to one another, the magnetic fields generated during operation by the conductor portions that extend in each case in two spaces adjacent to one another on the first plane each having a z-component of the same sign at location z=0 on the z-axis, and the magnetic fields generated, during operation, by the conductor portions that extend in each case in two spaces adjacent to one another on the second or third plane each having a z-component of opposite sign at location z=0 on the z-axis.

8. Magnet assembly according to any of the preceding claims, **characterized in that**, when projected on a cylinder about the z-axis a shim current path (5, 5', 5", 5''', 5"", 5''''', 5'''''') comprises more than two conductor portions that extend in the azimuthal direction and are electrically interconnected by connecting portions extending in other directions.

9. Magnet assembly according to any of the preceding claims, **characterized in that** a shim current path (5, 5', 5", 5''', 5"", 5''''', 5'''''') is produced from an HTS strip conductor or from an HTS-coated film, the HTS material consisting of ReBCO, in particular YBCO or GdBCO or BSCCO.

10. Magnet assembly according to any of the preceding claims, **characterized in that** the shim device (3) comprises at least two closed superconducting shim current paths (5, 5', 5", 5''', 5"", 5''''', 5'''''') that are inductively decoupled from one another such that $|L_{12}|/\sqrt{L_1 L_2} \leq 0.2$, $L_1$ and $L_2$ being the self-inductance of the two shim current paths, and $L_{12}$ being the mutual inductance thereof.

11. Magnet assembly according to any of the preceding claims, **characterized in that**, when projected on a cylinder about the z-axis, a shim current path (5, 5', 5''', 5"", 5''''') overlaps or intersects with itself, in particular such that said current path is coiled cylindrically, in more than one layer, around the working volume (4), and/or such that the developable HTS layer exhibits at least one change in the direction of revolution about the z-axis.

12. Magnet assembly according to any of the preceding claims, **characterized in that** the shim device (3) comprises a plurality of closed superconducting shim current paths (5, 5', 5", 5''', 5"", 5''''', 5'''''') that are arranged so as to be radially above one another relative to the z-axis and extend axially and azimuthally in an identical manner.

13. Magnet assembly according to any of the preceding claims, **characterized in that** a shim current path (5, 5', 5", 5''', 5"", 5''''', 5'''''') comprises a superconducting switch (6).

14. Magnet assembly according to any of the preceding claims, **characterized in that** the superconducting main field magnet coil system (1) comprises coils made of an HTS conductor, and **in that** the main field magnet coil system (1) and the shim device (3) are cooled by a cryocooler to a temperature of between 10 K and 80 K.

15. Magnet assembly according to any of the preceding claims, **characterized in that** a shim current path (5, 5', 5", 5''', 5"", 5''''', 5'''''') extends, with respect to the z-axis, radially inside the superconducting main field magnet coil system (1) at least in part.

**Revendications**

1. Agencement magnétique pour un appareil de résonance magnétique, l'agencement magnétique comprenant un cryostat (2) et un système de bobines magnétiques de champ principal supraconductrices (1) disposé dans celui-ci pour générer un champ magnétique dans la direction d'un axe z dans un volume de travail (4) disposé autour du point z=0 situé sur l'axe z,

dans lequel un dispositif de shim (3) est disposé à l'intérieur du cryostat (2) pour le réglage de la distribution spatiale et/ou pour l'homogénéisation spatiale du champ magnétique généré par le système de bobines magnétiques de champ principal (1) dans le volume de travail (4), lequel dispositif de shim (3) présente au moins une piste conductrice de shim fermée de manière supraconductrice (5, 5', 5", 5''', 5"", 5''''', 5""") avec une couche supraconductrice à haute température, abrégée en couche HTS,

**caractérisé en ce**

**que** la piste conductrice de shim (5, 5', 5", 5''', 5"", 5''''', 5""") a un nombre de spires de 0 par rapport à l'axe z et la couche HTS forme une surface qui peut être développée géométriquement sur un plan de telle sorte que la géodésique dans la surface formée par la couche HTS entre deux points quelconques de cette surface ne soit pas modifiée de plus de 10 % par le développement géométrique sur un plan, que la piste conductrice de shim (5, 5', 5", 5''', 5"", 5''''', 5""") génère, en fonctionnement, un champ magnétique avec une composante axiale $B_z(r, z, \varphi)$ par rapport à un système de coordonnées cylindriques autour de l'axe z, qui, représenté dans la base des fonctions sphériques, présente autour de z=0 sensiblement un seul gradient de champ, en plus d'un gradient de champ de degré 0 ayant une valeur absolue $\geq 0$, et

**que** le contour intérieur et/ou extérieur du développement géométrique de la surface formée par la couche HTS décrit une courbe non convexe.

2. Agencement magnétique selon la revendication 1, **caractérisé en ce qu'**une piste conductrice de shim (5, 5', 5", 5''', 5"", 5''''', 5""") génère un seul gradient de champ pour l'une des fonctions sphériques $z^2-r^2/2$, $z^3-3/2-zr^2$, $r \cdot \cos(\varphi)$, $r \cdot \sin(\varphi)$, $3rz \cdot \cos(\varphi)$, $3rz \cdot \sin(\varphi)$, $3r^2 \cdot \cos(2\varphi)$ ou $3r^2 \cdot \sin(2\varphi)$.

3. Agencement magnétique selon l'une des revendications précédentes, **caractérisé en ce qu'**une piste conductrice de shim (5, 5', 5""") passe par deux parties d'espace qui sont séparées l'une de l'autre par un plan perpendiculaire à l'axe z, dans lequel les champs magnétiques qui sont générés en fonctionnement par les sections conductrices qui s'étendent dans les deux parties d'espace présentent chacun une composante z de même signe à l'emplacement z=0 sur l'axe z.

4. Agencement magnétique selon l'une des revendications précédentes, **caractérisé en ce qu'**une piste conductrice de shim (5") passe par 2n parties d'espace, avec n=1, 2, 3, ..., qui sont séparées les unes des autres par 2n-1 plans perpendiculaires à l'axe z, dans lequel les champs magnétiques qui sont générés en fonctionnement par les sections conductrices qui s'étendent dans chaque fois deux parties d'espace adjacentes l'une à l'autre présentent chacun une composante z de signe opposé à l'emplacement z=0 sur l'axe z.

5. Agencement magnétique selon l'une des revendications précédentes, **caractérisé en ce qu'**une piste conductrice de shim (5''') passe par quatre parties d'espace qui sont séparées les unes des autres par un premier plan perpendiculaire à l'axe z et un deuxième plan contenant l'axe z, dans lequel les champs magnétiques qui sont générés en fonctionnement par les sections conductrices qui s'étendent dans chaque fois deux parties d'espace adjacentes l'une à l'autre au niveau du premier plan présentent chacun une composante z de même signe à l'emplacement z=0 sur l'axe z, et dans lequel les champs magnétiques qui sont générés en fonctionnement par les sections conductrices qui s'étendent dans chaque fois deux parties d'espace adjacentes l'une à l'autre au niveau du deuxième plan présentent chacun une composante z de signe opposé à l'emplacement z=0 sur l'axe z.

6. Agencement magnétique selon l'une des revendications précédentes, **caractérisé en ce qu'**une piste conductrice de shim (5"") passe par quatre parties d'espace qui sont séparées les unes des autres par un premier plan perpendiculaire à l'axe z et un deuxième plan contenant l'axe z, dans lequel les champs magnétiques qui sont générés en fonctionnement par les sections conductrices qui s'étendent dans chaque fois deux parties d'espace adjacentes l'une à l'autre présentent une composante z de signe opposé à l'emplacement z=0 sur l'axe z.

7. Agencement magnétique selon l'une des revendications précédentes, **caractérisé en ce qu'**une piste conductrice de shim (5""") passe par huit parties d'espace qui sont séparées les unes des autres par un premier plan perpendiculaire à l'axe z et un deuxième et un troisième plan qui contiennent l'axe z et sont perpendiculaires entre eux, dans lequel les champs magnétiques qui sont générés en fonctionnement par les sections conductrices qui s'étendent dans chaque fois deux parties d'espace adjacentes l'une à l'autre au niveau du premier plan présentent chacun une composante z de même signe à l'emplacement z=0 sur l'axe z, et dans lequel les champs magnétiques qui sont générés en fonctionnement par les sections conductrices qui s'étendent dans chaque fois deux parties d'espace adjacentes l'une à l'autre au niveau du deuxième ou du troisième plan présentent chacun une composante z de signe opposé à l'emplacement z=0 sur l'axe z.

8. Agencement magnétique selon l'une des revendications précédentes, **caractérisé en ce que**, dans la projection sur un cylindre autour de l'axe z, une piste conductrice de shim (5, 5', 5", 5''', 5'''', 5''''', 5'''''') comprend plus de deux sections conductrices s'étendant dans la direction azimutale, qui sont reliées électriquement les unes aux autres par des sections de liaison s'étendant dans d'autres directions.

9. Agencement magnétique selon l'une des revendications précédentes, **caractérisé en ce qu'**une piste conductrice de shim (5, 5', 5", 5''', 5'''', 5''''', 5'''''') est constituée d'un conducteur en ruban HTS ou d'une feuille à revêtement HTS, le matériau HTS étant constitué de ReBCO, en particulier d'YBCO ou de GdBCO, ou de BSCCO.

10. Agencement magnétique selon l'une des revendications précédentes, **caractérisé en ce que** le dispositif de shim (3) présente au moins deux pistes conductrices de shim fermées de manière supraconductrice (5, 5', 5", 5''', 5'''', 5''''', 5'''''') qui sont découplées l'une de l'autre de manière inductive de telle sorte que $|L_{12}|/\sqrt{L_1 L_2} \leq 0{,}2$, où $L_1$ et $L_2$ sont les auto-inductances des deux pistes conductrices de shim et $L_{12}$ est leur inductance mutuelle.

11. Agencement magnétique selon l'une des revendications précédentes, **caractérisé en ce qu'**une piste conductrice de shim (5, 5', 5''', 5'''', 5'''''') se chevauche ou se croise elle-même dans la projection sur un cylindre autour de l'axe z, en particulier qu'elle est enroulée en plus d'une couche de manière cylindrique autour du volume de travail (4) et/ou que la couche HTS développable présente au moins un changement du sens de rotation autour de l'axe z.

12. Agencement magnétique selon l'une des revendications précédentes, **caractérisé en ce que** le dispositif de shim (3) comprend plusieurs pistes conductrices de shim fermées de manière supraconductrice (5, 5', 5", 5''', 5'''', 5''''', 5'''''') disposées radialement les unes au-dessus des autres par rapport à l'axe z et s'étendant de la même manière axialement et azimutalement.

13. Agencement magnétique selon l'une des revendications précédentes, **caractérisé en ce qu'**une piste conductrice de shim (5, 5', 5", 5''', 5'''', 5''''', 5'''''') présente un interrupteur supraconducteur (6).

14. Agencement magnétique selon l'une des revendications précédentes, **caractérisé en ce que** le système de bobines magnétiques de champ principal supraconductrices (1) comprend des bobines en conducteur HTS et que le système de bobines magnétiques de champ principal (1) et le dispositif de shim (3) sont refroidis à une température comprise entre 10 K et 80 K par un cryorefroidisseur.

15. Agencement magnétique selon l'une des revendications précédentes, **caractérisé en ce que**, par rapport à l'axe z, une piste conductrice de shim (5, 5', 5", 5''', 5'''', 5''''', 5'''''') s'étend radialement au moins partiellement à l'intérieur du système de bobines magnétiques de champ principal supraconductrices (1).

Fig. 1

Fig. 2a

Fig. 2b

Fig. 3

Fig. 4a

Fig. 4b

Fig. 5a

Fig. 5b

Fig. 6

Fig. 7a

Fig. 7b

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8965468 B2

- FR 2043465